# FASCICULE DE BREVET EUROPEEN

(11) **EP 0 824 267 B1**
(45) Date de publication et mention de la délivrance du brevet: **19.03.2003**
(21) Numéro de dépôt: 97401910.1
(22) Date de dépôt: 08.08.1997
(51) Int. Cl.: H01L 21/00

(54) **Dispositif de décollement de plaquettes et procédé de mise en oeuvre de ce dispositif**
Abtrennungsverfahren für Platten und Vorrichtung zur Durchführung dieses Verfahrens
Lift-off device for flat pieces and its use

(30) Priorité: 12.08.1996 FR 9610111
(43) Date de publication de la demande: 18.02.1998
(73) Titulaire: COMMISSARIAT A L'ENERGIE ATOMIQUE, 75015 Paris (FR)
(72) Inventeur: Laporte, Philippe, 38360 Sassenage (FR)
(74) Mandataire: Dubois-Chabert, Guy

(56) Documents cités:
- PATENT ABSTRACTS OF JAPAN vol. 16, no. 158 (E-1191), 17 avril 1992 & JP 04 010454 A (SANYO)
- PATENT ABSTRACTS OF JAPAN vol. 13, no. 33 (M-789), 25 janvier 1989 & JP 63 242842 A (MITSUBISHI)

## Description

La présente invention concerne un dispositif de décollement de plaquettes et son procédé de mise en oeuvre.

### Etat de la technique antérieure

Le domaine de l'invention est celui de l'électronique et de la technologie de fabrication de composants.

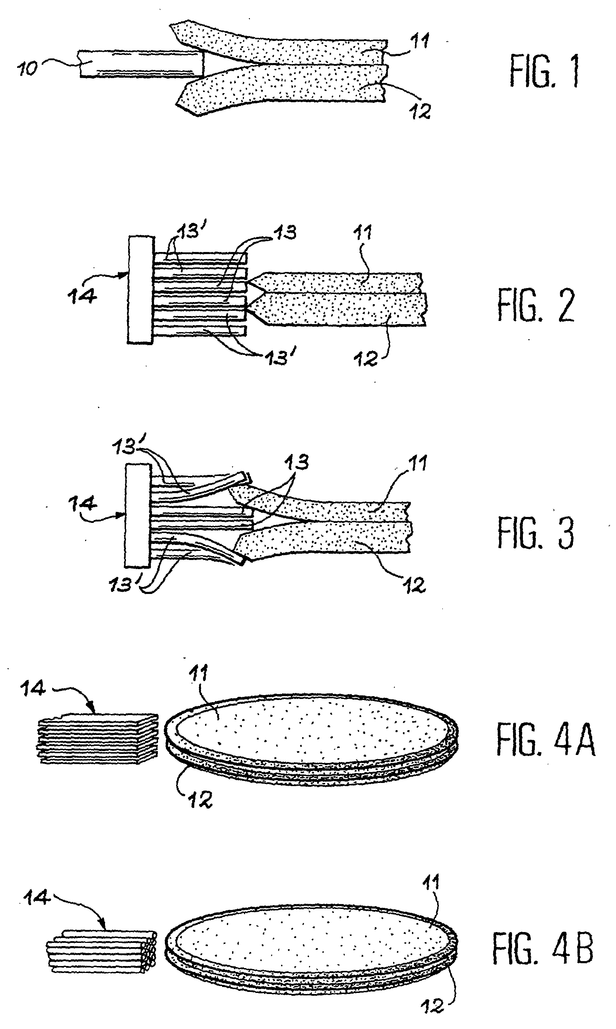

Dans un article intitulé « Bonding Of Silicon Wafers For Silicon-On-Insulator » de W.P. Maszara, G. Goetz, A. Caviglia et J.B. McKitterick (Applied Physics, 64(10), 15 novembre 1988, page 4943), on trouve une indication pour mesurer la force de liaison ou d'adhérence entre deux plaquettes « collées ». Pour cela une lame mince 10 est insérée entre les deux plaquettes 11 et 12, comme illustré sur la figure 1. La force d'adhérence est mesurée par la longueur sur laquelle s'étend le décollement. Il découle de cet article qu'il est possible de séparer deux plaquettes en utilisant une telle technique.

Par contre le décollement par lame simple, que présente cet article, n'est pas utilisé pour décoller les plaquettes comme une fin en soi, mais pour évaluer leur force d'attraction. Une telle solution nécessite la manipulation très précise (visée et guidage) de la lame pour l'insérer dans la jointure entre les deux plaquettes. Une telle précision est incompatible avec une automatisation rapide et bon marché de l'opération de décollement.

Dans le domaine de l'électronique de puissance on utilise des plaquettes de silicium de plus en plus minces (en comparaison au standard de la microélectronique). Cette évolution génère deux principaux problèmes :
- le premier est la manipulation de substrats qui sont de plus en plus fragiles aux chocs et qui deviennent flexibles ;
- le second est le non fonctionnement avec des plaquettes minces, de nombreux équipements réglés ou construits pour traiter des plaquettes d'épaisseur plus importante.

Ce problème peut devenir celui de la microélectronique traditionnelle, dans lequel on observe une augmentation du diamètre des plaquettes. Cette augmentation du diamètre s'accompagne d'une augmentation de l'épaisseur du substrat (pour des raisons mécaniques) alors que les dispositifs électroniques ne sont construits que dans une couche superficielle de plus en plus mince. Une solution consiste alors à construire le dispositif dans une couche mince de silicium collée sur un substrat vulgaire.

Cette solution mise en jeu pour construire des dispositifs sur des plaquettes minces utilise alors un « collage » provisoire de la plaque mince sur un support adapté en épaisseur au traitement à effectuer, mais de même diamètre. le collage n'utilise pas de couche adhésive mais simplement les forces d'attraction des surfaces, comme les forces de Vans der Walls, les forces électrostatiques, ou les caractéristiques hydrophiles des surfaces.

Le collage provisoire des plaquettes en cours de fabrication impose plusieurs contraintes concernant la manipulation des plaquettes :
- on ne doit pas affecter physiquement ou chimiquement la partie active des plaquettes, c'est-à-dire les zones dans lesquelles sont construits les dispositifs.
- les plaquettes doivent être manipulées seulement par la périphérie.

Plus précisément la plaquette active peut être recouverte par des couches fines actives comme de la résine photosensible. Aussi les éléments séparateurs doivent être réalisés dans une matière qui ne génère pas de pollution physique ou chimique au niveau des plaquettes, de nature à rendre les dispositifs réalisés sur ces dernières, inutilisables. En particulier, pour des plaquettes pour la fabrication des composants électroniques, il ne faut pas que les éléments séparateurs ramènent des composés alcalins comme le sodium ou le potassium, ni de métaux lourds comme l'or.

En outre la dureté des matériaux des éléments séparateurs doit être inférieure aux couches rencontrées pour ne pas générer de rayures dans la zone de contact avec les plaquettes.

Enfin le matériau des éléments séparateurs doit être également suffisamment autoconsistant pour ne pas se délaminer ou desquamer et générer des particules susceptibles de se fixer sur les plaquettes.

Un document de l'art connu, l'agrégé japonais vol. 16, N° 158 (E.1191) (17 avril 1992 et JP-A-04 010 454, Sanyo), décrit un dispositif de pulvérisation permettant de séparer des plaquettes en appliquant une force extérieure aux sections exposées de ces plaquettes, les positions des facettes des plaquettes de rang impair différant de celles des facettes des plaquettes de rang pair et l'espace des plaquettes étant distribué par ensembles de deux.

Le problème est de disposer d'une solution technique pour décoller les plaquettes, qui soit automatisable, rapide, et qui ne génère pas de dégradation des plaquettes et des couches déposées sur la plaquette active. l'utilisation d'une lame, comme décrit ci-dessus, impose une visée très précise de l'espace laissé entre les plaquettes à leur périphérie (au moins une plaquette doit avoir un bord profilé). Après décollement des plaquettes il faut maîtriser le mouvement de chacune des deux plaquettes.

L'invention a pour objet d'apporter une solution au problème du décollement de plaquettes dans le cadre des contraintes évoquées ci-dessus en rendant moins critique le problème de positionnement.

### Exposé de l'invention

La présente invention concerne un dispositif de décollement de plaquettes collées entre elles par l'intermédiaire de forces d'attraction, caractérisé en ce qu'il comprend au moins un ensemble d'au moins deux éléments flexibles dont la largeur dans une direction perpendiculaire aux plans des plaquettes est inférieure au plus grand écart entre les extrémités des plaquettes, et au moins une des plaquettes comporte une extrémité biseautée.

Dans une première variante les éléments flexibles sont des lames minces.

Dans une seconde variante les éléments flexibles sont des cylindres.

Avantageusement ledit dispositif comprend plusieurs structures séparatrices comportant chacune au moins deux éléments flexibles.

Ce dispositif peut comprendre un dispositif aspirant tel que par exemple une pipette aspirante.

Avantageusement chaque ensemble d'éléments flexibles (ou structure séparatrice) est maintenu dans un carénage pour limiter la déformation latérale et assurer une bonne pénétration entre les deux plaquettes.

Avantageusement l'extrémité des éléments flexibles est différente selon les configurations de plaquettes.

L'invention concerne également un procédé de mise en oeuvre de ce dispositif, dans lequel on réalise le décollement en au moins un point de la périphérie des plaquettes et dans lequel on maintient le décollement par insertion d'au moins un élément mécanique entre les deux plaquettes ou par soufflage de gaz pour empêcher les deux plaquettes de se coller à nouveau ou encore par escamotage d'au moins une des plaquettes.

L'invention propose une solution avantageuse à la manipulation de plaquettes et intéresse donc les équipementiers qui proposent des machines dans ce domaine. Les principaux marchés intéressés sont en particulier ceux de la fabrication des composants de puissance et des composants de type mémoire, microprocesseurs et composants à forte densité d'intégration, les fabricants de plaquettes type SOI.

### Brève description des dessins

- La figure 1 illustre un dispositif de l'art antérieur ;
- les figures 2 et 3 illustrent le dispositif de l'invention ;
- les figures 4A à 7C illustrent différentes variantes de réalisation du dispositif de l'invention.

### Exposé détaillé de modes de réalisation

L'invention concerne un dispositif de décollement de plaquettes, par exemple de silicium.

Dans la suite, on va considérer successivement les deux fonctions de décollement des plaquettes et de maintien du décollement.

Pour le décollement l'invention considère un ensemble d'au moins deux éléments fins flexibles 13 et 13' (appelés aussi séparateurs ou encore structures séparatrices) qui sont amenés au contact du biseau des plaquettes 11 et 12, comme illustré sur les figures 2 et 3, au moins une de ces plaquettes ayant un extrémité biseautée. Sur ces figures on a représenté six éléments flexibles.

Sur la figure 2 les éléments 13 et 13' sont approchées des plaquettes 11, 12 qui sont collées, les éléments 13 venant naturellement en bonne position, les éléments 13' n'ayant alors pas d'action.

Sur la figure 3, lorsque les éléments sont rapprochées des plaquettes, les éléments 13, ici au nombre de deux, écartent les plaquettes 11 et 12.

Ces éléments 13 et 13' doivent avoir une épaisseur inférieure à l'écart laissé par le ou les biseaux des tranches dans la direction perpendiculaire aux surfaces des plaquettes. Par exemple, pour deux plaquettes 11 et 12 de 240 µm d'épaisseur, avec un biseau symétrique, cette dimension sera inférieure à 230 µm. Ces éléments 13 et 13' peuvent avoir une dimension quelconque dans la direction parallèle à la surface.

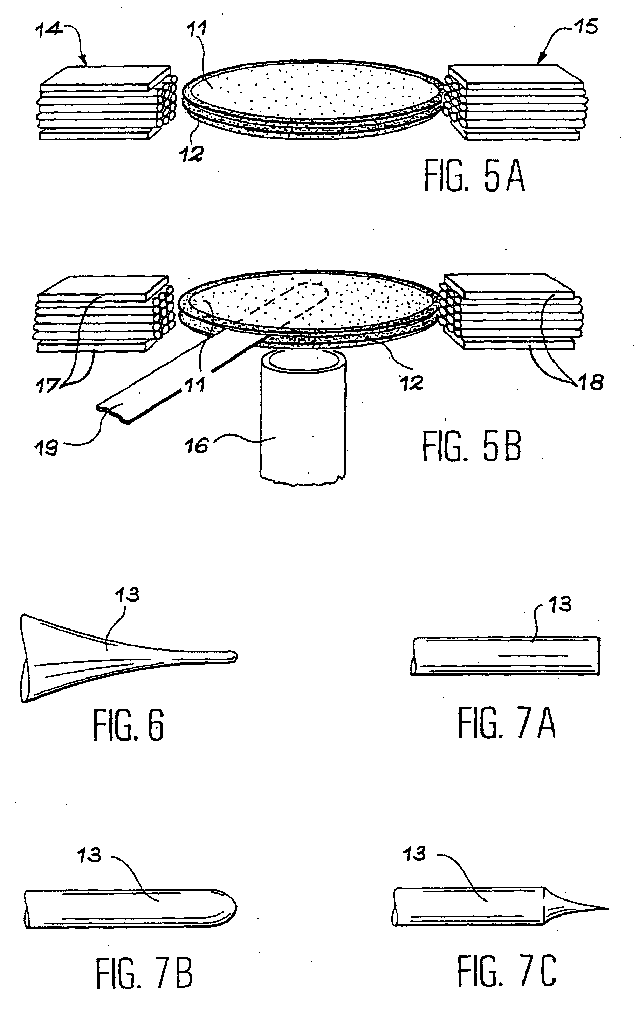

Le décollement doit être assuré en au moins un point (ou zone) de la périphérie des plaquettes, mais plusieurs points répartis sur la périphérie peuvent être utilisés comme illustré sur les figures 5A et 5B.

Sur la figure 4A les séparateurs sont des lames minces.

Sur la figure 4B les séparateurs sont des cylindres.

Sur la figure 5A plusieurs structures séparatrices 14, 15 sont utilisées en même temps.

Sur la figure 5B un dispositif aspirant 16, par exemple une pipette aspirante, permet d'escamoter la plaquette support et évite ainsi le recollement. Le recollement peut également être évité par soufflage de gaz entre les plaquettes ou par insertion d'un élément mécanique 19.

Dans l'invention la mise en oeuvre d'un ensemble d'éléments 13, 13' assure qu'au moins un élément se trouve naturellement en bonne position pour assurer l'écartement des plaquettes.

L'excursion mécanique des éléments flexibles vers le centre des plaquettes est limitée à une zone extérieure aux zones actives, ce qui garantit le respect des zones actives de la plaquette.

L'opération de séparation peut, bien entendu, être appliquée à plusieurs plaquettes simultanément. Ainsi dans un mode de réalisation on peut décoller un ensemble de plaquettes disposé dans une cassette. La plaquette support est retirée par exemple par une pipette aspirante tandis que les autres plaquettes décollées restent rangées dans la cassette en vue d'un traitement ultérieur.

Comme illustré sur les figures 5A et 5B, tout ensemble d'éléments séparateurs peut être maintenu dans un carénage (ou carter) 17, 18 pour limiter la déformation latérale et assurer la bonne pénétration entre les deux plaquettes.

Le profil des éléments séparateurs peut être variable, par exemple de largeur croissante (de l'extérieur vers la base), comme illustré sur la figure 6, pour accentuer la séparation des deux plaquettes 11 et 12. En outre, l'extrémité de ces éléments séparateurs peut être adaptée en fonction des configurations comme illustré sur les figures 7A, 7B et 7C, qui représentent trois profils possibles mais non limitatifs de l'extrémité d'un élément séparateur. Ce profil peut ainsi être optimisé en fonction de la conformation des plaquettes à séparer (par exemple : profil parallélépipédique, rond ou encore effilé).

Pour maintenir le décollement, le dispositif de l'invention peut être complété par exemple, par l'insertion d'un élément mécanique de préférence plus rigide qu'un élément flexible entre les deux plaquettes ou par un soufflage de gaz qui-empêche les deux plaquettes de se coller à nouveau.

La mise en oeuvre de ces deux fonctions de décollement des plaquettes et de maintien du décollement permet de séparer rapidement et automatiquement des paires de plaquettes.

Dans un exemple de réalisation on utilise une structure de: type « brosse à dents » composée de faisceaux de poils de Nylon. Chaque poil a un diamètre d'environ 100 µm et une longueur d'environ 9 mm. Chaque faisceau est constitué d'une cinquantaine de poils dans un diamètre de 1,5 mm. Les faisceaux sont organisés en quatre rangées de sept. Chaque faisceau est distant de 2,5 mm de faisceau voisin. l'extrémité des poils correspond à la forme illustrée sur la figure 7B. La course latérale est limitée à 8 mm par un carter en PVC. Ce carter libère l'extrémité des poils sur 3 mm.

Les éléments séparateurs sont réalisés dans une matière qui ne génère pas de pollution physique ni chimique au niveau des plaquettes, de nature à rendre inutilisables les dispositifs réalisés sur ces dernières. En particulier, pour des plaquettes pour la fabrication des composants électroniques, il ne faut pas ramener des composés alcalins comme le sodium ou le potassium, ni de métaux lourds comme l'or. La dureté des matériaux est de préférence inférieure à celle des couches rencontrées pour ne pas générer de rayures dans la zone de contact avec les plaquettes. Le matériau est également de préférence suffisamment autoconsistant pour ne pas se délaminer ou desquamer et générer de particules susceptibles de se fixer sur les plaquettes.

## Revendications

1. Dispositif de décollement de plaquettes (11, 12) collées par l'intermédiaire de forces d'attraction, **caractérisé en ce qu'**il comprend au moins un ensemble (14) d'au moins deux éléments flexibles (13, 13') dont la largeur dans une direction perpendiculaire aux plans des plaquettes est inférieure aux plus grand écart entre les extrémités des plaquettes (11, 12), et au moins une des plaquettes (11, 12) comporte une extrémité biseautée.

2. Dispositif selon la revendication 1, **caractérisé en ce que** les éléments flexibles (13, 13') sont des lames minces.

3. Dispositif selon la revendication 1, **caractérisé en ce que** les éléments flexibles (13, 13') sont des cylindres.

4. Dispositif selon la revendication 1, **caractérisé en ce qu'**il comprend plusieurs ensembles (14, 15) comportant chacune au moins deux éléments flexibles.

5. Dispositif selon la revendication 1, **caractérisé en ce qu'**il comprend un dispositif aspirant (16).

6. Dispositif selon l'une quelconque des revendications précédentes, **caractérisé en ce qu'**un ensemble d'éléments flexibles est maintenu dans un carénage (17, 18).

7. Dispositif selon la revendication 1, **caractérisé en ce que** l'extrémité des éléments flexibles est différente selon les configurations de plaquettes.

8. Procédé de mise en oeuvre du dispositif selon l'une quelconque des revendications précédentes, **caractérisé en ce qu'**on réalise le décollement en au moins un point de la périphérie des plaquettes, et **en ce que** l'on maintient ledit décollement.

9. Procédé selon la revendication 8, **caractérisé en ce que** le maintien dudit décollement est réalisé par insertion d'au moins un élément mécanique (19) entre les deux plaquettes.

10. Procédé selon la revendication 8, **caractérisé en ce que** le maintien du décollement est réalisé par soufflage de gaz qui empêche les deux plaquettes de se coller à nouveau.

11. Procédé selon la revendication 8, **caractérisé en ce que** le maintien du décollement est réalisé par escamotage d'au moins une des plaquettes au moyen d'un dispositif aspirant (16).

## Patentansprüche

1. Vorrichtung zum Abtrennen von Platten (11, 12), die durch Anziehungskräfte aneinander kleben,
**dadurch gekennzeichnet, dass** sie wenigstens ein Teil (14) mit wenigstens zwei flexiblen Elementen (13, 13') umfasst, deren Breite in einer zu den Ebenen der Platten senkrechten Richtung kleiner ist als der größte Abstand zwischen den Enden der Platten (11, 12), und dass wenigstens eine der Platten (11, 12) ein abgeschrägtes bzw. abgefastes Ende aufweist.

2. Vorrichtung nach Anspruch 1, **dadurch gekennzeichnet, dass** die flexiblen Elemente (13, 13') dünne Lamellen sind.

3. Vorrichtung nach Anspruch 1, **dadurch gekennzeichnet, dass** die flexiblen Elemente (13, 13') Zylinder sind.

4. Vorrichtung nach Anspruch 1, **dadurch gekennzeichnet, dass** sie mehrere Teile (14, 15) umfasst, von denen jedes wenigstens zwei flexible Elemente aufweist.

5. Vorrichtung nach Anspruch 1, **dadurch gekennzeichnet, dass** sie eine Saugeinrichtung (16) umfasst.

6. Vorrichtung nach einem der vorangehenden Ansprüche, **dadurch gekennzeichnet, dass** ein Gehäuse (17, 18) einem Gruppe flexibler Elemente Halt verleiht.

7. Vorrichtung nach Anspruch 1, **dadurch gekennzeichnet, dass** das Ende der flexiblen Elemente je nach den Konfigurationen bzw. Formen der Platten verschieden ist.

8. Verfahren zum Anwenden der Vorrichtung nach einem der vorangehenden Ansprüche, **dadurch gekennzeichnet, dass** man die Abtrennung an wenigstens einem Punkt des Rands der Platten realisiert, und dadurch, dass man diese Abtrennung aufrechterhält.

9. Verfahren nach Anspruch 8, **dadurch gekennzeichnet, dass** die Aufrechterhaltung der genannten Abtrennung durch Einführung wenigstens eines mechanischen Elements (19) zwischen den beiden Platten realisiert wird.

10. Verfahren nach Anspruch 8, **dadurch gekennzeichnet, dass** die Aufrechterhaltung der Abtrennung durch das Einblasen von Gas realisiert wird, das die beiden Platten daran hindert, wieder aneinander zu kleben.

11. Verfahren nach Anspruch 8, **dadurch gekennzeichnet, dass** die Aufrechterhaltung der Abtrennung realisiert wird, indem man wenigstens eine der Platten mit Hilfe einer Saugeinrichtung (16) beiseite schafft.

## Claims

1. Device for the separation of wafers (11, 12) bonded by means of forces of attraction, **characterized in that** it comprises at least one assembly (14) of at least two flexible elements (13, 13'), whose width in a direction perpendicular to the planes of the wafers is less than the largest gap between the ends of the wafers (11, 12) and at least one of the wafers (11, 12) has a bevelled end.

2. Device according to claim 1, **characterized in that** the flexible elements (13, 13') are thin plates.

3. Device according to claim 1, **characterized in that** the flexible elements (13, 13') are cylinders.

4. Device according to claim 1, **characterized in that** it comprises several assemblies (14, 15), each having at least two flexible elements.

5. Device according to claim 1, **characterized in that** it comprises a suction means (16).

6. Device according to any one of the preceding claims, **characterized in that** an assembly of flexible elements is maintained in a fairing (17, 18) in order to limit the lateral deformation and ensure a good penetration between the two wafers.

7. Device according to claim 1, **characterized in that** the end of the flexible elements differs in accordance with the configurations of the wafers.

8. Process for the use of the device according to any one of the preceding claims, **characterized in that** separation takes place at at least one point of the periphery of the wafers and said separation is maintained.

9. Process according to claim 8, **characterized in that** the maintaining of said separation is brought about by inserting at least one mechanical element (19) between two wafers.

10. Process according to claim 8, **characterized in that** the maintainind of the separation is brought about by the blowing of gases, which prevents the two wafers from rebonding.

11. Process according to claim 8, **characterized in that** the maintaining of the separation is brought about by moving away at least one of the wafers by using a suction means (16).
